# EUROPÄISCHE PATENTSCHRIFT

(11) **EP 3 348 666 B1**
(45) Veröffentlichungstag und Bekanntmachung des Hinweises auf die Patenterteilung: **03.06.2020**
(21) Anmeldenummer: 18151402.7
(22) Anmeldetag: 12.01.2018
(51) Int. Cl.: C23C 14/30, C23C 14/56, F01D 5/28, C23C 14/50

(54) **VORRICHTUNG UND VERFAHREN ZUR BESCHICHTUNG VON WERKSTÜCKEN**
APPARATUS AND METHOD FOR COATING WORKPIECES
DISPOSITIF ET PROCÉDÉ DE REVÊTEMENT DE PIÈCES

(30) Priorität: 12.01.2017 DE 102017100507
(43) Veröffentlichungstag der Anmeldung: 18.07.2018
(73) Patentinhaber: ALD Vacuum Technologies GmbH, 63457 Hanau (DE)
(72) Erfinder: Wittich, Jörg, 64853 Otzberg (DE); Oberle, Simon, 63906 Erlenbach (DE); Hotz, Jürgen, 64839 Münster (DE)
(74) Vertreter: Fuchs Patentanwälte Partnerschaft mbB

(56) Entgegenhaltungen:
- DE-A1-102012 102 465
- US-B1- 6 589 351

## Beschreibung

Die vorliegende Erfindung betrifft eine Vorrichtung und ein Verfahren zur Beschichtung von Werkstücken, insbesondere zum Beschichten von Turbinenschaufeln. Das Verfahren ist vorzugsweise ein PVD-Verfahren (Physical Vapor Deposition), insbesondere EB/PVD-Verfahren (Electron Beam). Bei den Beschichtungen handelt es sich insbesondere um Wärmedämmschichten, die auch TBC-Schichten (Thermal Barrier Coatings) genannt werden.

Turbinenschaufeln sind im Betrieb sehr hohen Temperaturen und Temperaturgradienten ausgesetzt. Mit der Wärmedämmschicht wird die Hitzeresistenz der Werkstücke erhöht und damit auch die Lebensdauer im Betrieb verlängert. Für das Beschichten von Turbinenschaufeln mittels EB/PVD werden diese insbesondere in eine Vakuumatmosphäre eingeschleust und anschließend in einer Vorheizzone aufgeheizt, um dann in der Prozesszone unter Vakuum und hoher Temperatur unter definierten Bewegungsprofilen beschichtet zu werden. Dies geschieht mit Hilfe eines sogenannten Manipulators. Generell ist der Bereich der Prozesszone sehr heiß und es fällt Schmutz, insbesondere in Form von abrasiven Stäuben an. Somit sind die Anforderungen an das Material des Manipulators und aller anderen Bauteile in diesem Bereich sehr hoch.

### Stand der Technik

Im Stand der Technik sind Vorrichtungen und Verfahren zum Beschichten von Turbinenschaufeln mittels EB/PVD-Verfahren bekannt.

Beispielsweise lehrt EP 2 520 689 A1 eine EB/PVD-Vorrichtung und ein Verfahren zum Beschichten von Werkstücken. Die Vorrichtung weist einen Manipulator auf, der ein Werkstück in einer ausgefahrenen Position in einer Beschichtungskammer und in einer zurückgezogenen Position außerhalb der Beschichtungskammer hält. Der Manipulator ist mit einer Wärmehaube versehen, die mit dem Werkstück zusammen aus der Behandlungskammer gezogen wird. Der Manipulator kann einen Außenteil und einen Innenteil aufweisen. Dabei ist der Innenteil relativ zum Außenteil beweglich. Der Innenteil kann das Werkstück halten und der Außenteil hält die Wärmehaube. Der Innenteil ist relativ zum Außenteil um die Manipulatorlängsachse drehbar. Die Vorrichtung kann neben der Beschichtungskammer eine Einschleuskammer und eine Vorheizkammer aufweisen. Während der Beschichtung kann das Werkstück gedreht werden. Der Aufbau der Vorrichtung in diesem Dokument des Standes der Technik macht es erforderlich, Dichtungen in der Behandlungskammer vorzusehen (siehe Abbildung 6, Bezugszeichen 332). Es ist nachteilig, Dichtungen und bewegliche Teile der Vorrichtung in der Behandlungskammer - dem Bereich der größten Temperatur- und Staubbelastung - vorzusehen, so dass es wünschenswert ist, die Anzahl derartiger Bauteile in diesem Bereich so gering wie möglich zu halten. Insgesamt ist die Vorrichtung in der zitierten Druckschrift im Bereich der Behandlungskammer verhältnismäßig komplex aufgebaut mit dem Nachteil, dass erhöhter Wartungsaufwand anfällt.

EP 2 157 204 A1 lehrt ebenfalls ein Beschichtungsverfahren und eine Vorrichtung zur Durchführung des Verfahrens. Das Verfahren ist ein EB/PVD-Verfahren zum Abscheiden von Wärmedämmschichten. Ein Manipulator ist nicht beschrieben.

EP 2 374 913 A1 lehrt ebenfalls ein Beschichtungsverfahren und eine Vorrichtung zur Durchführung des Verfahrens. Das Verfahren ist ein EB/PVD-Verfahren zum Abscheiden von Wärmedämmschichten. Es sind eine Beschichtungskammer und eine Vorheizkammer vorgesehen. In der dort beschriebenen Vorrichtung ist eine Halterung für Werkstücke an einem Manipulator befestigt. Der Manipulator kann das Werkstück von einer Einschleuskammer in die Vorheizkammer und die Beschichtungskammer bewegen. Eine Rotationsbewegung der Werkstücke ist auf diese Weise nicht möglich.

EP 2 468 918 A2 betrifft eine Vorrichtung zum Abscheiden von Beschichtungen auf Werkstücken. Die Vorrichtung weist eine Vielzahl von Halterungen auf, die geeignet sind, Werkstücke aufzunehmen. Das durchgeführte Verfahren ist ein EB/PVD-Verfahren. Es ist ein Manipulator vorgesehen, der entlang seiner Längsachse verschiebbar und um die Längsachse drehbar ausgeführt ist. Auf diese Weise können die Werkstücke in der Beschichtungskammer rotiert werden, um eine möglichst gleichmäßige Beschichtung zu erzielen. Mit einer speziellen Werkstück-Halterung sollen auch ansonsten schwer zugängliche Bereiche der Werkstücke beschichtet werden können.

Auch EP 2 236 643 A2 beschreibt eine EB/PVD-Vorrichtung zum Abscheiden von Beschichtungen auf Werkstücken. Über eine Steuereinheit soll die Bewegung des Werkstückes während der Beschichtung eingestellt werden. Es ist ein Manipulator vorgesehen, um das Werkstück vor und zurück zu bewegen und es in der Beschichtungskammer zu halten. Zu diesem Zweck weist der Manipulator einen Schaft auf. Der Manipulator ist ferner geeignet, das Werkstück innerhalb der Beschichtungskammer in Rotation zu versetzen. Weitere Details zum Manipulator fehlen.

Ferner offenbart DE 10 2012 102 465 A1 einen Teleskoparm zum bidirektionalen translatorischen Substrattransport bei der Vakuumbehandlung. Der Teleskoparm umfasst ein äußeres und ein inneres Schubmittel zum Bewegen eines äußeren und eines inneren Teleskoprohres. Die Teleskoprohre sind innerhalb eines Hauptrohres angeordnet, das als ein mit einer Wand einer Vakuumkammer verbundener Teil der Wand ausgeführt ist, sodass die Wand der Vakuumkammer eine zylinderförmige Ausstülpung nach außen aufweist.

Die Lösungen des Standes der Technik haben den Nachteil, dass der Manipulator im Bereich der Prozesszone komplex aufgebaut und somit anfällig für Störungen ist. Auch der Einsatz von Dichtungen und beweglichen Bauteilen in dem Bereich des Manipulators, der sich während des Betriebs in der Prozesszone befindet, ist ungünstig. Besonders störungsanfällig sind der Antrieb sowie eventuell vorhandene Fahrwagen oder Schienen für den Manipulator. Häufig wird der Antrieb des Manipulators im Vakuumbereich angeordnet, wodurch nicht nur die Standzeit der Vorrichtung reduziert wird, sondern auch die gesamte Anlage größer ausgelegt werden muss. Da das EB/PVD-Verfahren unter Vakuum durchgeführt wird, steigen Kosten und apparativer Aufwand mit der Größe der Prozesskammern erheblich an.

### Aufgabe

Es ist daher eine Aufgabe der vorliegenden Erfindung, eine Vorrichtung und ein Verfahren bereit zu stellen, mit denen eine Beschichtung von Werkstücken unter reduziertem Wartungsaufwand, reduziertem Energieaufwand und reduziertem apparativen Aufwand möglich ist.

### Beschreibung der Erfindung

Die Aufgabe wird durch die Gegenstände der Patentansprüche gelöst.

### Vorrichtung

Die der Erfindung zu Grunde liegende Aufgabe wird gelöst durch eine Vorrichtung zum Beschichten von Werkstücken, insbesondere von Turbinenschaufeln, mit wenigstens einer Einschleuskammer und wenigstens einer Prozesszone, wobei die Vorrichtung wenigstens einen Manipulator mit einer Halterung umfasst, an der eines oder mehrere Werkstücke befestigt werden können, wobei die Halterung wenigstens teilweise beweglich, insbesondere um eine Längsachse des Manipulators drehbar, ist, wobei der Manipulator in Richtung der Längsachse, insbesondere horizontal, verschiebbar ist, und wobei die Halterung in Richtung der Längsachse des Manipulators von der Einschleuskammer in die Prozesszone bewegbar ist. Der Manipulator weist eine Welle auf, die in die Einschleuskammer einführbar ist und geeignet ist, die Halterung und/oder daran befindlichen Werkstücken in Bewegung, insbesondere in Rotationsbewegung, zu versetzen, wobei die Einschleuskammer eine Durchführung aufweist, die auf einer der Prozesszone abgewandten Seite der Einschleuskammer angeordnet ist, und wobei die Durchführung wenigstens zwei ineinander schiebbare Teleskopsegmente aufweist und die Welle durch die Teleskopsegmente verläuft, wobei ein erstes Teleskopsegment einen kleineren Durchmesser aufweist als ein zweites Teleskopsegment, wobei in einem Zwischenbereich zwischen einem Abschnitt des Außenumfangs des ersten Teleskopsegments und einem Abschnitt des Innenumfangs des zweiten Teleskopsegment wenigstens eine Dichtung in Form eines oder mehrerer Dichtungsringe angeordnet ist. Die Teleskopsegmente sind dabei auf der außerhalb der Einschleuskammer liegenden Seite der Durchführung angeordnet und ihr Bewegungsbereich verläuft überwiegend außerhalb der Einschleuskammer. Überwiegend bedeutet im Sinne dieser Anmeldung > 50 %, vorzugsweise > 66 %, > 75 %, insbesondere > 95 % und schließt auch 100 % mit ein.

Wenn in dieser Beschreibung auf "ein Werkstück" Bezug genommen wird, so schließt dies ausdrücklich eine Mehrzahl von Werkstücken ein. Üblicherweise und erfindungsgemäß bevorzugt werden an der Halterung mehrere Werkstücke gemeinsam befestigt, gleichermaßen werden in dem Verfahren mehrere Werkstücke gleichzeitig beschichtet. Die Halterung ist insbesondere geeignet, wenigstens 2, insbesondere wenigstens 4, wenigstens 6 oder wenigstens 8 Werkstücke zu halten. Vorzugsweise ist die Zahl der Werkstücke auf höchstens 24, insbesondere höchstens 20, höchstens 18 oder höchstens 14 begrenzt. Es hat sich gezeigt, dass diese Mengen an Werkstücken in Anbetracht der üblichen Maße von Turbinenschaufeln und anderen mit der Vorrichtung behandelbaren Werkstücken besonders geeignet sind, um bei einer verhältnismäßig kleinen Vorrichtung eine möglichst große Effizienz zu erzielen.

Besonders vorteilhaft weist die Vorrichtung mehrere Einschleuskammern auf, so dass die Auslastung der Prozesszone erhöht werden kann. Insbesondere ist jeder Einschleuskammer ein Manipulator und/oder eine erfindungsgemäße Durchführung mit Teleskopsegmenten zugeordnet. Während ein beschichtetes Werkstück ausgeschleust wird, kann bereits ein weiteres Werkstück über eine freie Einschleuskammer eingeschleust werden. Es ist besonders vorteilhaft, wenigstens zwei, wenigstens drei oder wenigstens vier Einschleuskammern vorzusehen. Aufgrund der im Vergleich zum Stand der Technik relativ geringen Größe der erfindungsgemäß eingesetzten Einschleuskammern, kann eine Mehrzahl solcher Kammern in einer Vorrichtung eingesetzt werden. In einer besonders bevorzugten Ausführungsform sind mehrere Vorheizzonen (bzw. Vorheizkammern) vorgesehen, so dass die Effizienz weiter gesteigert werden kann. Vorzugsweise ist jeder Einschleuskammer eine Vorheizzone (bzw. Vorheizkammer) zugeordnet. Dadurch lässt sich der Durchsatz nochmals erheblich steigern.

Die Vorrichtung dieser Erfindung kann aufgrund dieser Ausgestaltung verhältnismäßig klein ausgeführt werden. Dadurch, dass die Welle durch die Teleskopsegmente verläuft, kann eine Antriebseinheit für die Welle außerhalb der Einschleuskammer angeordnet werden. Dies ist besonders vorteilhaft, da die Antriebseinheit eine gewisse Größe aufweist und mit empfindlichen Bauteilen ausgestattet ist. Durch die besondere Ausgestaltung der vorliegenden Erfindung kann die Antriebseinheit außerhalb der Zone angeordnet werden, wo besonders hohe Temperaturen auftreten und Schmutz anfällt. Die Ausgestaltung der Durchführung für die Welle in Form einer Teleskopdurchführung, die sich auf einer der Prozesszone abgewandten Seite der Einschleuskammer befindet und nach außen teleskopiert, erlaubt es, die für die Teleskopdurchführung erforderlichen Dichtungen und Führungen möglichst weit von der Prozesszone entfernt anzuordnen, so dass der Verschleiß reduziert wird und eine vergleichsweise einfache Wartung dieser Vorrichtungsteile ermöglicht ist. In der Prozesszone der Vorrichtung entstehen unvermeidbar abrasive Stäube, die die Lebensdauer von beweglichen Teilen beeinträchtigen. Je weniger bewegliche Teile in dem Einflussbereich der abrasiven Stäube angeordnet werden, desto geringer ist der Wartungsaufwand in dieser Hinsicht. Die erfindungsgemäße Vorrichtung erlaubt es, empfindliche Teile wie die Dichtungen im Zwischenbereich der Teleskopsegmente, Führungen der Teleskopsegmente, Antriebseinheiten und Führungen für die Antriebseinheiten außerhalb der Prozesszone und mit vergleichsweise großem Abstand zu dieser Zone der größten thermischen und abrasiven Belastung anzuordnen. Ferner kann die erfindungsgemäße Vorrichtung einen verhältnismäßig kleinen Vakuumbereich haben, da Antrieb und Fahrwagen für die Manipulatorwelle außerhalb der Kammern angeordnet werden können. Somit reicht für den Betrieb der Vorrichtung eine kleinere Vakuumpumpe aus.

Der Manipulator weist wenigstens die Welle und die Halterung auf. Der Manipulator kann mehr als eine Welle aufweisen, wobei die Wellen vorzugsweise koaxial verlaufen. Die Halterung kann mehr als einen Haltearm aufweisen. So ist es insbesondere vorstellbar, dass die Halterung sich in zwei oder mehr Haltearme teilt, an denen jeweils Vorkehrungen zum Halten von einem oder mehreren Werkstücken vorgesehen sein können (z.B. Haltepins). Die Werkstücke können an der Halterung um ihre eigene Achse drehbar sein, um eine möglichst gleichmäßige Beschichtung zu erreichen. Ferner kann die Halterung um die Längsachse der Welle(n) drehbar sein. Es sind auch weitere Bewegungsmuster der Halterung erfindungsgemäß, die zu einer gleichmäßigeren Beschichtung der Werkstücke führen.

In einer Ausführungsform umfasst die Vorrichtung eine Vorheizzone. Die Vorheizzone dient zum Vorheizen der Werkstücke. Sie ist vorzugsweise zwischen der Einschleuskammer und der Prozesszone angeordnet. In dem Verfahren wird somit zunächst wenigstens ein zu behandelndes Werkstück in die Einschleuskammer eingeführt und an der Halterung befestigt. Nach Verschließen der Einschleuskammer in Richtung der Umgebung kann diese evakuiert werden. Das Werkstück kann dann in die Vorheizzone bewegt werden, um das Werkstück auf eine erhöhte Temperatur vor zu heizen. Von der Vorheizzone kann das Werkstück in die Prozesszone bewegt werden, um beschichtet zu werden. Nach dem Beschichten kann das beschichtete Werkstück aus der Prozesszone zurück in die Einschleuskammer bewegt werden, die auch zum Ausschleusen der beschichteten Werkstücke dienen kann.

Die Vorheizzone und/oder die Prozesszone sind vorzugsweise als gasdichte Kammern ausgestaltet. Die Einschleuskammer ist vorzugsweise als gasdichte Kammer ausgestaltet. In einer Ausführungsform der Erfindung ist zwischen Einschleuskammer und Prozesszone bzw. Prozesskammer eine gasdicht verschließbare Öffnung zur Durchführung von an der Halterung befestigten Werkstücken vorgesehen. In einer Ausführungsform, die neben der Einschleuskammer und der Prozesszone bzw. Prozesskammer auch eine Vorheizzone bzw. Vorheizkammer aufweist, ist vorzugsweise zwischen Einschleuskammer und Vorheizzone und/oder zwischen Vorheizzone und Prozesszone eine gasdicht verschließbare Öffnung zur Durchführung von an der Halterung befestigten Werkstücken vorgesehen.

"Kammer" bedeutet erfindungsgemäß, dass der so bezeichnete Teil der Vorrichtung in alle Raumrichtungen mindestens eine Abgrenzung aufweist. Diese kann in einer geschlossenen Wandung bestehen, oder die Wandung kann eine oder mehrere Öffnungen aufweisen. Die Öffnungen können verschließbar, insbesondere gasdicht verschließbar sein. Vorzugsweise sind die Kammern und insbesondere die gesamte Vorrichtung in geschlossenem Zustand gasdicht. "Gasdicht" bedeutet im Sinne der vorliegenden Erfindung, dass die Volumenleckrate in einem als "gasdicht" bezeichneten Raum (z.B. einer Prozesskammer), bzw. an einer als "gasdicht" bezeichneten verschlossenen Öffnung oder Dichtung, weniger als 1*10⁻² mbar*l/s, insbesondere weniger als 5*10⁻³ mbar*l/s, beträgt. Die Volumenleckrate wird vorzugsweise bei 20°C und 1013 hPa Umgebungsdruck gemessen.

Es ist nicht ausgeschlossen, dass die Kammern weitere, hier nicht ausdrücklich genannte Öffnungen aufweisen. Diese sind im Falle von gasdichten Kammern zur Umgebung hin verschließbar. Insbesondere weist die Einschleuskammer wenigstens eine verschließbare Einschleusöffnung auf, durch die Werkstücke in die Einschleuskammer eingebracht werden können. Durch dieselbe oder eine weitere verschließbare Öffnung können beschichtete Werkstücke wieder aus der Vorrichtung entnommen werden.

In einer Ausführungsform befindet sich die Einschleusöffnung der Einschleuskammer auf der Seite der Einschleuskammer, die der Prozesszone zugewandt ist. In einer solchen Ausführungsform wird die Einschleuskammer vorzugsweise verschiebbar sein, insbesondere in Richtung der Längsachse des Manipulators. Das Öffnen der Einschleusöffnung erfolgt dann insbesondere durch Verschieben der Einschleuskammer entlang der Längsachse des Manipulators in Richtung der Teleskopsegmente, so dass die Teleskopsegmente zumindest teilweise ineinander geschoben werden und die Halterung freigelegt wird. Um die Einschleusöffnung zu schließen, wird die Einschleuskammer zurück in Richtung der Prozesszone über die Halterung geschoben, so dass die Einschleuskammer wieder gasdicht verschlossen ist. Die Halterung wird während des Öffnens und Schließens der Einschleuskammer insbesondere nicht bewegt (Einschleusposition). Die Außenwandung einer Vorheiz- bzw. Prozesskammer kann insbesondere eine Dichtung aufweisen, um die Einschleusöffnung gasdicht zu verschließen. Die Einschleuskammer kann verfahrbar sein, insbesondere auf Schienen, beispielsweise auf denselben Schienen wie die Antriebseinheit.

Die Einschleuskammer weist ferner bevorzugt eine verschließbare Öffnung zur Prozesszone oder zur Vorheizzone auf. Die Vorheizzone weist, sofern sie als Kammer ausgestaltet ist, vorzugsweise wenigstens eine Öffnung zur Einschleuskammer und wenigstens eine Öffnung zur Prozesszone auf. Eine oder beide der Öffnungen können gasdicht verschließbar sein, vorzugsweise ist die Öffnung zur Einschleuskammer gasdicht verschließbar, da in der Einschleuskammer zeitweise Umgebungsdruck vorherrschen kann. Die Prozesszone kann, sofern sie als Kammer ausgestaltet ist, eine verschließbare Öffnung zu der Einschleuskammer und/oder, wenn vorhanden, zu der Vorheizzone aufweisen. Darüber hinaus kann die Prozesskammer weitere Öffnungen aufweisen, insbesondere können verschließbare Öffnungen vorgesehen sein, um Materialquellen, insbesondere Ingots, aus dem Beschichtungsmaterial einzuführen. Ferner können eine oder mehrere der Kammern, insbesondere Einschleus- und/oder Prozesskammer, Absaugöffnungen aufweisen, um eine oder mehrere Vakuumpumpen anzuschließen.

In einer Ausführungsform der Erfindung weist die Durchführung mindestens 3, bevorzugt mindestens 4 und besonders bevorzugt mindestens 5 Teleskopsegmente auf. Vorzugsweise ist die Zahl der Teleskopsegmente erfindungsgemäß auf höchstens 12, mehr bevorzugt höchstens 8 und besonders bevorzugt höchstens 6 Teleskopsegmente beschränkt. Wird eine zu große Zahl an Teleskopsegmenten eingesetzt, steigt die Anzahl der Dichtstellen und der Durchmesser der Durchführung, was nachteilig ist. Die hierin beschriebenen Merkmale der Teleskopsegmente im Hinblick auf die Zwischenbereiche, Zwischenabsaugungen, Dichtungen, Verdrehsicherungen und/oder Führungen treffen erfindungsgemäß bevorzugt auf mehrere, insbesondere alle Teleskopsegmente, zu.

Vorzugsweise weist die Durchführung eine oder mehrere Verdrehsicherungen auf, um ein Verdrehen der Teleskopsegmente zu vermeiden. Die Verdrehsicherung kann in einem Verbindungsstück zwischen einem Abschnitt des Außenumfangs eines Teleskopsegments mit einer Führung, insbesondere einer Führungsschiene, bestehen. Dabei ist das Verbindungsstück auf der Schiene verschiebbar, so dass es mit den Teleskopsegmenten entlang der Längsachse bewegbar ist. Somit wird ein Verdrehen der Teleskopsegmente und vorzugsweise auch eine übermäßige mechanische Beanspruchung der Teleskopsegmente und Gleitführungen vermieden.

Die in dem Zwischenbereich angeordnete Dichtung kann in einem oder mehreren Dichtungselementen, wie insbesondere Dichtungsringen (z.B. O-Ringen oder Quadringen), bestehen. Zwei Dichtungselemente können einen Dichtungszwischenraum bilden. Die Vorrichtung kann in dem genannten Zwischenbereich eine Absaugung aufweisen, um einen Unterdruck im Dichtungszwischenraum zu erzielen. Die Dichtung kann insbesondere wenigstens zwei Dichtungsringe aufweisen, die beabstandet voneinander in dem Zwischenbereich angeordnet sind und wenigstens einen Zwischenraum bilden. In dem Zwischenraum kann mit der Absaugung ein Unterdruck eingestellt werden. Dies hat den Vorteil, dass das Eindringen von Umgebungsluft auch im Falle von Rissen oder Kratzern wirksam vermieden wird.

In dem Zwischenbereich kann insbesondere auch eine Führung, insbesondere Gleitführung, vorgesehen sein, um die Verschiebbarkeit der Teleskopsegmente ineinander zu unterstützen und um für ein ungehindertes Ineinanderschieben bzw. Gleiten zu sorgen. Die Führung umfasst wenigstens ein Führungsinnenelement an dem Außenumfang des Teleskopsegmentes mit dem kleineren Durchmesser und wenigstens ein Führungsaußenelement an dem Innenumfang des Teleskopsegmentes mit dem größeren Durchmesser. Das Führungsinnenelement erstreckt sich vorzugsweise über eine Länge von wenigstens 50%, mehr bevorzugt wenigstens 70% und weiter bevorzugt wenigstens 90% der Länge des Teleskopsegmentes, an dem das Element befestigt ist, in Richtung der Längsachse des Manipulators. Folglich kann das Führungsinnenelement in einem auseinandergezogenen Zustand zu einem Teil, insbesondere zu einem Großteil (>50%), außerhalb des Zwischenbereichs angeordnet sein. So wird gewährleistet, dass die Teleskopsegmente über eine große Länge ineinander schiebbar sind, mit dem Ergebnis, dass der Manipulator weit in den Innenbereich der Vorrichtung geschoben werden kann. Als Führungselemente kommen jegliche dem Fachmann geläufige Führungen, insbesondere Gleitführungen, in Betracht. Vorzugsweise weist jedes Teleskopsegment wenigstens eine, insbesondere wenigstens zwei Führungen auf.

Als "erstes Teleskopsegment" wird erfindungsgemäß das Segment mit dem im Vergleich zu den anderen Teleskopsegmenten kleinsten Querschnittsdurchmesser bezeichnet. Als "größtes Teleskopsegment" wird erfindungsgemäß das Segment mit dem im Vergleich zu den anderen Teleskopsegmenten größten Querschnittsdurchmesser bezeichnet. Das Teleskopsegment, welches mit der Einschleuskammer verbunden ist, wird hierin auch als "Basissegment" bezeichnet. In einer Ausführungsform ist das erste Teleskopsegment mit der Antriebseinheit verbunden. In einer anderen Ausführungsform ist das größte Teleskopsegment mit der Antriebseinheit verbunden. Die Verbindung wird vorzugsweise gasdicht ausgeführt. Sie erfolgt insbesondere über Flansche. Die Teleskopsegmente bilden zusammen einen nach außen geschlossenen Raum innerhalb der Durchführung. Die Teleskopsegmente weisen entlang der Manipulatorlängsachse Öffnungen auf, die es erlauben, zumindest die Welle hindurch zu führen. Die Öffnungen können auch größer sein, zumal Dichtungen in diesem Bereich nicht erforderlich sind. Die Teleskopsegmente können kreisrunde Querschnitte haben, so dass von "Röhrensegmenten" gesprochen werden kann. Alternativ können die Querschnitte auch rechteckig, vieleckig oder von beliebiger anderer Form sein, solange die Formen der jeweils benachbarten Segmente aufeinander abgestimmt sind. Die Teleskopsegmente sind vorzugsweise nur in Richtung der Manipulatorlängsachse mit Öffnungen versehen und im Übrigen, d.h. im Bereich der Mantelflächen, geschlossen ausgeführt. Sofern doch Öffnungen vorgesehen werden, so sind diese gasdicht verschließbar.

Der Ausdruck, dass wenigstens "zwei ineinander schiebbare Teleskopsegmente" vorgesehen sind, bedeutet, dass eines der beiden Teleskopsegmente, nämlich das mit dem kleineren Durchmesser, zumindest teilweise (insbesondere zu mindestens 50%, mindestens 70% oder mindestens 90% der Länge des kleineren Teleskopsegments) in das andere Teleskopsegment geschoben werden kann. Vorzugsweise ist jedes erfindungsgemäß eingesetzte Teleskopsegment in ein anderes Teleskopsegment schiebbar, mit Ausnahme des größten Teleskopsegments. Ein Teleskopsegment kann in das Basissegment einschiebbar sein, welches an der Einschleuskammer angeordnet ist. Das Basissegment hat dann selbstverständlich einen größeren Durchmesser als das in das Basissegment einschiebbare Teleskopsegment. Das Basissegment selbst ist insbesondere nicht in ein weiteres Teleskopsegment einschiebbar. Das Basissegment ist vorzugsweise fest, z.B. mit einem Flansch, mit der Einschleuskammer verbunden. Die Summe der Längen der Teleskopsegmente ist wenigstens so groß wie der Abstand zwischen einer Einschleusposition in der Einschleuskammer, an der sich die Halterung des Manipulators beim Einschleusen von Werkstücken befindet, und einer Beschichtungsposition in der Prozesszone, an der sich die Halterung des Manipulators beim Beschichten befindet.

Die Antriebseinheit ist insbesondere entlang der Manipulatorlängsachse verfahrbar. Die Verfahrbarkeit kann vorzugsweise durch Führungen erzielt werden, die parallel mit und insbesondere unterhalb der Manipulatorlängsachse verlaufen. Die Führungen können insbesondere Schienen sein und/oder die Antriebseinheit kann auf einem Fahrwagen auf den Führungen verfahrbar sein. Die Einschleuskammer kann, wenn sie ebenfalls verfahrbar ist, ebenfalls auf Führungen, insbesondere auf denselben Führungen wie die Antriebseinheit, verfahrbar angeordnet sein.

### Verfahren

Erfindungsgemäß ist auch ein Verfahren zum Beschichten von Werkstücken, insbesondere von Turbinenschaufeln, mit den Schritten
- Einbringen eines oder mehrerer Werkstücke in die Einschleuskammer einer Vorrichtung gemäß der vorliegenden Erfindung und Befestigen des Werkstückes an der Halterung,
- oder Einbringen eines oder mehrerer an einer Halterung befestigten Werkstücke in die Einschleuskammer einer Vorrichtung der vorliegenden Erfindung und Befestigen der Halterung an dem Manipulator,
- Bewegen des Werkstücks mittels eines Manipulators von der Einschleuskammer in die Prozesszone oder in eine Vorheizzone und anschließend in die Prozesszone,
- Beschichten des Werkstückes in der Prozesszone, und
- Entnehmen des beschichteten Werkstückes aus der Vorrichtung,
wobei während des Bewegens des Werkstückes in die Prozesszone oder in eine Vorheizzone und anschließend in die Prozesszone, die Teleskopsegmente ineinander geschoben werden.

Die Beschichtung, die in dem erfindungsgemäßen Verfahren aufgebracht wird, ist vorzugsweise eine Wärmedämmbeschichtung, die insbesondere Y₂O₃-stabilisiertes ZrO₂, Mullit, Al₂O₃, CeO₂, Seltenerdzirkonate, Seltenerdoxide und/oder Metall-Glas-Kompositmaterialien umfasst oder daraus besteht. Bevorzugt umfasst das Beschichtungsmaterial Y₂O₃-stabilisiertes ZrO₂, Gd2O₃, Yb₂O₃ und/oder Nd₂O₃ insbesondere besteht das Beschichtungsmaterial daraus. In einer Ausführungsform kann das Beschichtungsmaterial Metalle oder Metalllegierungen umfassen oder daraus bestehen, insbesondere sind dies Metalle oder Metalllegierungen auf der Basis von Nickel, Chrom und/oder Kobalt wie insbesondere NiCoCrAlY.

Das Verfahren umfasst ferner vorzugsweise das Einbringen und wenigstens teilweise Verdampfen einer Materialquelle, insbesondere eines Ingots des Beschichtungsmaterials.

Das Beschichten erfolgt vorzugsweise unter Vakuum, insbesondere bei einem Druck von <50 Pa, <40 Pa, <30 Pa, <20 Pa oder kleiner <10 Pa. Das Beschichten erfolgt vorzugsweise bei einer Temperatur von wenigstens 800°C, insbesondere wenigstens 850°C oder wenigstens 900°C. Die Temperatur sollte vorzugsweise einen Wert von 1250°C, 1200°C oder 1100°C nicht überschreiten.

Ein detaillierter Verfahrensablauf gemäß einer bevorzugten Ausführungsform verläuft wie folgt, wobei jeder in dieser bevorzugten Ausführungsform dargestellte Verfahrensschritt für sich genommen in Kombination mit dem Gegenstand des Anspruchs 12 eine selbständige bevorzugte Ausgestaltung des erfindungsgemäßen Verfahrens darstellt.
- Einbringen eines oder mehrerer Werkstücke in die Einschleuskammer einer Vorrichtung gemäß der vorliegenden Erfindung und Befestigen des Werkstückes an der Halterung,
- oder Einbringen eines an einer Halterung befestigten Werkstückes in die Einschleuskammer einer Vorrichtung gemäß der vorliegenden Erfindung und Befestigen der Halterung an dem Manipulator,
- Verschließen der verschließbaren Einschleusöffnung der Einschleuskammer,
- Evakuieren der Einschleuskammer,
- Öffnen einer verschließbaren Öffnung zwischen Einschleuskammer und Vorheizzone, oder zwischen Einschleuskammer und Prozesszone,
- Bewegen des an dem Manipulator befestigten Werkstücks von der Einschleuskammer in die Prozesszone, oder in die Vorheizzone und anschließend in die Prozesszone unter Ineinanderschieben der Teleskopsegmente,
- Rotation des Werkstückes an dem Manipulator in der Prozesszone, währenddessen Beschichten des Werkstückes in der Prozesszone,
- Zurückziehen des beschichteten, an dem Manipulator befestigten Werkstückes aus der Prozesszone zurück in die Einschleuskammer unter Auseinanderziehen der Teleskopsegmente,
- Verschließen einer verschließbaren Öffnung zwischen Einschleuskammer und Vorheizzone, beziehungsweise zwischen Einschleuskammer und Prozesszone,
- Öffnen der verschließbaren Einschleusöffnung oder Ausschleusöffnung der Einschleuskammer, und
- Entnehmen des beschichteten Werkstückes aus der Vorrichtung.

### Figurenbeschreibung

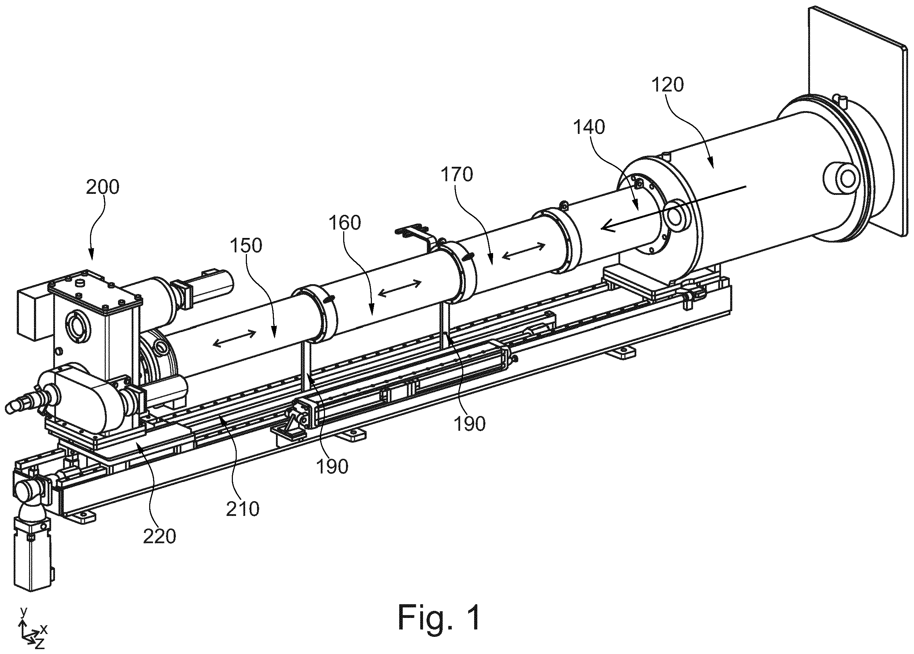

**Figur 1** zeigt eine erfindungsgemäße Vorrichtung mit insgesamt vier Teleskopsegmenten 150, 160, 170, 140, wobei das mit der Einschleuskammer verbundene Teleskopsegment hierin auch als Basissegment 140 bezeichnet wird. Die Teleskopsegmente sind ineinander schiebbar. Das Teleskopsegment 170 ist in das Basissegment 140 schiebbar. Die Richtung der möglichen Verschiebung ist mit Pfeilen auf den Teleskopsegmenten gezeigt. Einschleuskammer 120 und Basissegment 140 sind gemeinsam verschiebbar, symbolisiert durch einen gemeinsamen Pfeil. Innerhalb der Teleskopsegmente verläuft der Manipulator (nicht gezeigt), der eine Welle aufweist, die mit der Antriebseinheit 200 verbunden ist. Die Antriebseinheit 200 befindet sich an einem Fahrwagen 220, der auf Führungen, nämlich Schienen 210, verfahrbar ist. Die Teleskopsegmente 160 und 170 sind mit Verdrehsicherungen 190 gegen Verdrehen gesichert. Die Verdrehsicherungen 190 bestehen in einer Verbindung zwischen den Teleskopsegmenten und den Führungen 210. Die Vorrichtung weist eine Einschleuskammer 120 auf, die mit einer Durchführung ausgestattet ist, deren Bestandteil die Teleskopsegmente 150, 160 sowie 170 und das Basissegment 140 sind. Die Durchführung befindet sich an einem Ende der Einschleuskammer 120, das von der Prozesszone abgewandt ist. Die Einschleuskammer 120 ist auf den Schienen 210 verfahrbar, um eine Einschleusöffnung öffnen und schließen zu können, die auf der der Prozesszone der Einschleuskammer 120 zugewandten Seite angeordnet ist.

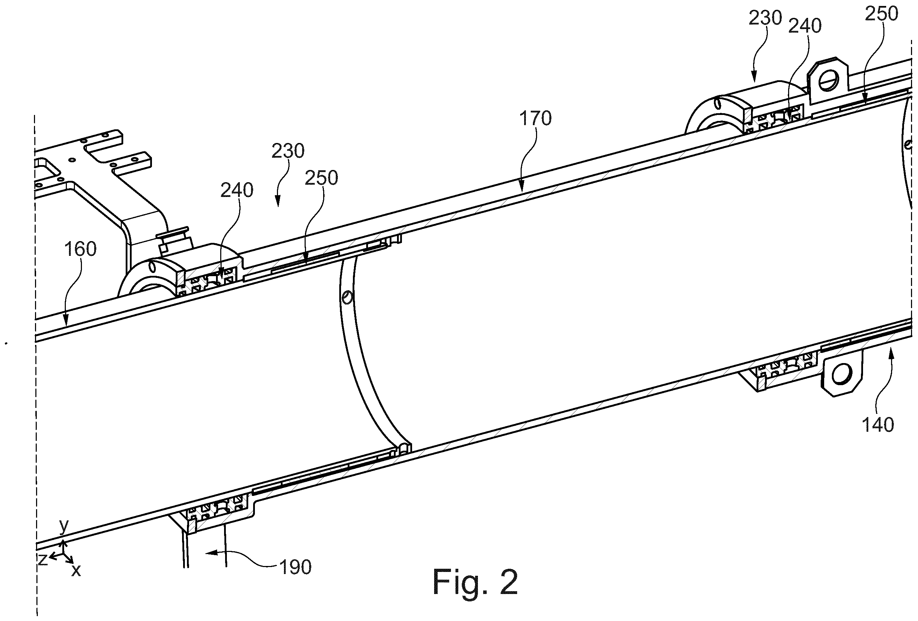

**Figur 2** zeigt eine Detailansicht von erfindungsgemäß eingesetzten Teleskopsegmenten 160, 170 und Basissegment 140. Zwischen einem Abschnitt des Außenumfangs des jeweils kleineren Teleskopsegmentes 160, 170 und einem Abschnitt des Innenumfangs des benachbarten größeren Teleskopsegmentes 170 bzw. Basissegments 140 bilden sich Zwischenbereiche 230. In den Zwischenbereichen sind Dichtungen 240 und Gleitführungen 250 angeordnet. Auch eine Verdrehsicherung 190 ist erkennbar. Diese ist erfindungsgemäß bevorzugt am Außenumfang des größeren Teleskopsegmentes den Dichtungen 240 gegenüber liegend angeordnet.

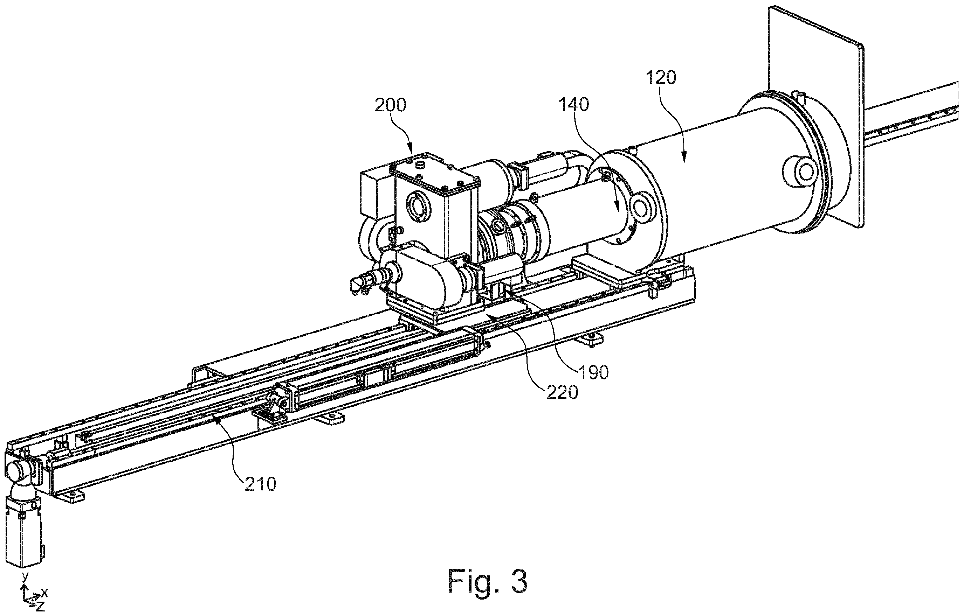

**Figur 3** zeigt eine erfindungsgemäße Vorrichtung mit ineinander geschobenen Teleskopsegmenten, wobei nur das Basissegment 140 sichtbar ist. Der Manipulator (nicht gezeigt) ist durch die Einschleuskammer 120 in die Prozesszone (nicht gezeigt) geschoben. Die Antriebseinheit 200 ist auf einem Fahrwagen 220 angeordnet, der auf Schienen 210 verfahrbar ist.

### Bezugszeichenliste

- 120: Einschleuskammer
- 140: Basissegment
- 150: erstes Teleskopsegment
- 160: zweites Teleskopsegment
- 170: drittes Teleskopsegment
- 190: Verdrehsicherung
- 200: Antriebseinheit
- 210: Schienen
- 220: Fahrwagen
- 230: Zwischenbereich
- 240: Dichtung
- 250: Gleitführung

## Patentansprüche

1. Vorrichtung zum Beschichten von Werkstücken, insbesondere von Turbinenschaufeln, mit wenigstens einer Einschleuskammer (120) und wenigstens einer Prozesszone,
wobei die Vorrichtung wenigstens einen Manipulator mit einer Halterung umfasst, an der eines oder mehrere Werkstücke befestigt werden können, wobei die Halterung wenigstens teilweise beweglich ist, wobei der Manipulator in Richtung seiner Längsachse verschiebbar ist, und wobei die Halterung in Richtung der Längsachse des Manipulators von der Einschleuskammer (120) in die Prozesszone bewegbar ist, wobei der Manipulator eine Welle aufweist, die in die Einschleuskammer (120) einführbar ist und geeignet ist, die Halterung und/oder an der Halterung befindliche Werkstücke in Bewegung zu versetzen,
**dadurch gekennzeichnet, dass** die Einschleuskammer (120) eine Durchführung aufweist, die auf einer der Prozesszone abgewandten Seite der Einschleuskammer angeordnet ist, und wobei die Durchführung wenigstens zwei ineinander schiebbare Teleskopsegmente (140, 150, 160, 170) aufweist und die Welle durch die Teleskopsegmente verläuft,
wobei ein erstes Teleskopsegment (150) einen kleineren Durchmesser aufweist als ein zweites Teleskopsegment (160), wobei in einem Zwischenbereich (230) zwischen einem Abschnitt des Außenumfangs des ersten Teleskopsegments (150) und einem Abschnitt des Innenumfangs des zweiten Teleskopsegments (160) wenigstens eine Dichtung (240) in Form eines oder mehrerer Dichtungsringe angeordnet ist.

2. Vorrichtung nach Anspruch 1, wobei die Summe der Längen der Teleskopsegmente (140, 150, 160, 170) wenigstens so groß ist wie der Abstand zwischen einer Einschleusposition in der Einschleuskammer (120), an der sich die Halterung des Manipulators beim Einschleusen von Werkstücken befindet, und einer Beschichtungsposition in der Prozesszone, an der sich die Halterung des Manipulators beim Beschichten befindet.

3. Vorrichtung nach Anspruch 1 oder 2, wobei die Vorrichtung mehrere Einschleuskammern (120) aufweist, der jeweils ein Manipulator und eine Durchführung mit Teleskopsegmenten (140, 150, 160, 170) zugeordnet ist.

4. Vorrichtung nach einem der vorhergehenden Ansprüche, wobei das Teleskopsegment (150) mit dem kleinsten Durchmesser mit der Antriebseinheit (200) verbunden ist.

5. Vorrichtung nach wenigstens einem der vorhergehenden Ansprüche, wobei die Durchführung mindestens 3, mindestens 4 oder mindestens 5, insbesondere aber höchstens 12, höchstens 8 oder höchstens 6 Teleskopsegmente (140, 150, 160, 170) aufweist.

6. Vorrichtung nach wenigstens einem der vorhergehenden Ansprüche, wobei die Durchführung eine oder mehrere Verdrehsicherungen (190) aufweist, um ein Verdrehen der Teleskopsegmente (140, 150, 160, 170) zu vermeiden.

7. Vorrichtung nach wenigstens einem der vorhergehenden Ansprüche, wobei in dem Zwischenbereich (230) eine Absaugung zwischen zwei Dichtungselementen (240) vorgesehen ist.

8. Vorrichtung nach wenigstens einem der vorhergehenden Ansprüche, wobei in dem Zwischenbereich (230) wenigstens eine Gleitführung (250) vorgesehen ist, um die Verschiebbarkeit der Teleskopsegmente (140, 150, 160, 170) aufeinander zu unterstützen.

9. Vorrichtung nach wenigstens einem der vorhergehenden Ansprüche, wobei die Welle mit einer Antriebseinheit (200) außerhalb der Einschleuskammer (120) verbunden ist.

10. Vorrichtung nach Anspruch 9, wobei die Antriebseinheit (200) entlang der Manipulatorlängsachse, insbesondere auf Schienen (210), verfahrbar ist.

11. Vorrichtung nach wenigstens einem der vorhergehenden Ansprüche, wobei die Einschleuskammer (120) auf Führungen (210) verfahrbar ist, so dass durch Verfahren der Einschleuskammer (129) ein Öffnen und Schließen der Einschleusöffnung erzielt werden kann.

12. Verfahren zum Beschichten von Werkstücken, insbesondere von Turbinenschaufeln, mit den Schritten
- Einbringen eines oder mehrerer Werkstücke in die Einschleuskammer (120) einer Vorrichtung gemäß einem der Ansprüche 1 bis 11 und Befestigen des Werkstückes an der Halterung,
- oder Einbringen eines oder mehrerer an einer Halterung befestigten Werkstücke in die Einschleuskammer (120) und befestigen der Halterung an dem Manipulator,
- Bewegen des Werkstücks von der Einschleuskammer (120) (i) in die Prozesszone, oder (ii) in eine Vorheizzone und anschließend in die Prozesszone,
- Beschichten des Werkstückes in der Prozesszone, und
- Entnehmen des beschichteten Werkstückes aus der Vorrichtung,
**dadurch gekennzeichnet, dass** während des Bewegens des Werkstückes (i) in die Prozesszone, oder (ii) in eine Vorheizzone und anschließend in die Prozesszone, die Teleskopsegmente (140, 150, 160, 170) ineinander geschoben werden.

## Claims

1. An apparatus for the coating of workpieces, in particularly of turbine blades, with at least one loading chamber (120) and at least one process zone, wherein the apparatus comprises at least one manipulator with a holder on which one or several workpieces can be mounted, wherein the holder can at least partially be moved, wherein the manipulator is slidable in the direction of its longitudinal axis, and wherein the holder is movable in the direction of the longitudinal axis of the manipulator from the loading chamber (120) into the process zone, wherein the manipulator comprises a shaft which can be inserted into the loading chamber (120) and is suitable to set the holder and/or workpieces being placed on the holder in motion,
**characterized in that** the loading chamber (120) comprises a feed-through which is arranged on the side of the loading chamber being the far side with respect to the process zone, and wherein the feed-through comprises at least two telescopic segments (140, 150, 160, 170) which are slidable into each other and the shaft passes through the telescopic segments, wherein a first telescopic segment (150) has a smaller diameter than a second telescopic segment (160), wherein in an intermediate zone (230) between a section of the outer circumference of the first telescopic segment (150) and a section of the inner circumference of the second telescopic segment (160) at least one sealing (240) in the form of one or several sealing rings is arranged.

2. The apparatus according to claim 1, wherein the sum of the lengths of the telescopic segments (140, 150, 160, 170) is at least as high as the distance between a loading position in the loading chamber (120) at which the holder of the manipulator is placed during loading of workpieces and a coating position in the process zone at which the holder of the manipulator is placed during coating.

3. The apparatus according to claim 1 or 2, wherein the apparatus comprises several loading chambers (120), to which a manipulator and a feed-through with telescopic segments (140, 150, 160, 170) are assigned each.

4. The apparatus according to one of the preceding claims, wherein the telescopic segment (150) with the smallest diameter is connected with the drive unit (200).

5. The apparatus according to at least one of the preceding claims, wherein the feed-through comprises at least 3, at least 4 or at least 5, but in particularly at most 12, at most 8 or at most 6 telescopic segments (140, 150, 160, 170).

6. The apparatus according to at least one of the preceding claims, wherein the feed-through comprises one or several anti-twist devices (190) for avoiding twisting of the telescopic segments (140, 150, 160, 170).

7. The apparatus according to at least one of the preceding claims, wherein in the intermediate zone (230) an extraction system between two sealing elements (240) is provided.

8. The apparatus according to at least one of the preceding claims, wherein in the intermediate zone (230) at least one slip-in guide (250) is provided, for supporting the slidability of the telescopic segments (140, 150, 160, 170) into one another.

9. The apparatus according to at least one of the preceding claims, wherein the shaft is connected with a drive unit (200) outside the loading chamber (120).

10. The apparatus according to claim 9, wherein the drive unit (200) is displaceable along the longitudinal axis of the manipulator, in particularly on rails (210).

11. The apparatus according to at least one of the preceding claims, wherein the loading chamber (120) is displaceable on guides (210) so that by displacing the loading chamber (129) an opening and closing of the loading opening can be achieved.

12. A method for the coating of workpieces, in particularly of turbine blades, with the steps of
- introducing one or several workpieces into the loading chamber (120) of an apparatus according to one of claims 1 to 11 and mounting the workpiece on the holder,
- or introducing one or several workpieces being mounted on a holder into the loading chamber (120) and mounting the holder on the manipulator,
- moving the workpiece from the loading chamber (120) (i) into the process zone or (ii) into a preheating zone and subsequently into the process zone,
- coating the workpiece in the process zone, and
- removing the coated workpiece from the apparatus,
**characterized in that** during the moving of the workpiece (i) into the process zone or (ii) into a preheating zone and subsequently into the process zone the telescopic segments (140, 150, 160, 170) are slid into each other.

## Revendications

1. Dispositif de revêtement de pièces à usiner, en particulier d'aubes de turbine, avec au moins une chambre d'entrée (120) et au moins une zone de processus, dans lequel le dispositif comprend au moins un dispositif de manipulation avec un support, auquel une ou plusieurs pièces à usiner peuvent être fixées, dans lequel le support est au moins en partie mobile, dans lequel le dispositif de manipulation peut coulisser en direction de son axe longitudinal, et dans lequel le support peut être déplacé en direction de l'axe longitudinal du dispositif de manipulation de la chambre d'entrée (120) dans la zone de processus, dans lequel le dispositif de manipulation présente un arbre qui peut être introduit dans la chambre d'entrée et est adapté pour mettre en mouvement le support et/ou la pièce à usiner se trouvant au niveau du support,
**caractérisé en ce que** la chambre d'entrée (120) présente une mise en œuvre, qui est agencée sur un côté détourné de la zone de processus de la chambre d'entrée, et dans lequel la mise en œuvre présente au moins deux segments télescopiques (140, 150, 160, 170) pouvant coulisser l'un dans l'autre et l'arbre passe à travers les segments télescopiques,
dans lequel un premier segmenttélescopique (150) présente un diamètre plus petit qu'un second segmenttélescopique (160), dans lequel, dans une zone intermédiaire (230) entre une section de la circonférence extérieure du premier segment télescopique (150) et une section de la circonférence intérieure du second segment télescopique (160), au moins une étanchéité (240) est agencée sous forme d'un ou de plusieurs anneaux d'étanchéité.

2. Dispositif selon la revendication 1, dans lequel la somme des longueurs des segments télescopiques (140, 150, 160, 170) est au moins aussi grande que l'écart entre une position d'entrée dans la chambre d'entrée (120), où se trouve le support du dispositif de manipulation lors de l'introduction de pièces à usiner, et une position d'entrée dans la zone de processus, où se trouve le support du dispositif de manipulation lors de l'enduction.

3. Dispositif selon la revendication 1 ou 2, dans lequel le dispositif présente plusieurs chambres d'entrée (120), auxquelles sont respectivement associées un dispositif de manipulation et une mise en œuvre avec des segments télescopiques (140, 150, 160, 170).

4. Dispositif selon l'une quelconque des revendications précédentes, dans lequel le segment télescopique (150) avec le plus petit diamètre est relié avec l'unité d'entraînement (200).

5. Dispositif selon au moins l'une quelconque des revendications précédentes, dans lequel la mise en œuvre présente au moins 3, au moins 4 ou au moins 5, en particulier, mais au plus 12, au plus 8 ou au plus 6 segments télescopiques (140, 150, 160, 170).

6. Dispositif selon au moins l'une quelconque des revendications précédentes, dans lequel la mise en œuvre présente un ou plusieurs systèmes antirotation (190), pour éviter une rotation des segments télescopiques (140, 150, 160, 170).

7. Dispositif selon au moins l'une quelconque des revendications précédentes, dans lequel une aspiration entre deux éléments d'étanchéité (240) est prévue dans la zone intermédiaire (230).

8. Dispositif selon au moins l'une quelconque des revendications précédentes, dans lequel au moins un rail de guidage (250) est prévu dans la zone intermédiaire (230) pour soutenir le caractère coulissant des segments télescopiques (140, 150, 160, 170) l'un par rapport à l'autre.

9. Dispositif selon au moins l'une quelconque des revendications précédentes, dans lequel l'arbre est relié avec une unité d'entraînement (200) en dehors de la chambre d'entrée (120).

10. Dispositif selon la revendication 9, dans lequel l'unité d'entraînement (200) peut être déplacée le long de l'axe longitudinal du dispositif de manipulation, en particulier sur des rails (210).

11. Dispositif selon au moins l'une quelconque des revendications précédentes, dans lequel la chambre d'entrée (120) peut être déplacée sur des guides (210), de sorte qu'une ouverture et une fermeture de l'ouverture d'entrée peuvent être obtenues par le procédé de la chambre d'entrée (129).

12. Procédé de revêtement de pièces à usiner, en particulier d'aubes de turbine, avec les étapes consistant à
- introduire une ou plusieurs pièces à usiner dans la chambre d'entrée (120) d'un dispositif selon l'une quelconque des revendications 1 à 11 et fixer la pièce à usiner au support,
- ou introduire une ou plusieurs pièces à usiner fixées à un support dans la chambre d'entrée (120) et fixer le support au dispositif de manipulation,
- déplacer la pièce à usiner de la chambre d'entrée (120) (i) dans la zone de processus, ou (ii) dans une zone de chauffage préliminaire et ensuite dans la zone de processus,
- enduire la pièce à usiner dans la zone de processus, et
- retirer la pièce à usiner du dispositif,
**caractérisé en ce que**, pendant le déplacement de la pièce à usiner (i) dans la zone de processus, ou (ii) dans la zone de chauffage préliminaire un ensuite dans la zone de processus, les segments télescopiques (140, 150, 160, 170) sont emboîtés l'un dans l'autre.
